# EUROPEAN PATENT APPLICATION

(11) **EP 2 497 602 A1**
(43) Date of publication of application: **12.09.2012**
(21) Application number: 10828252.6
(22) Date of filing: 29.10.2010
(51) Int. Cl.: B24D 11/00, B24D 3/00, B24D 3/06

(54) **SUPER-ABRASIVE GRAIN FIXED TYPE WIRE SAW, AND METHOD OF MANUFACTURING SUPER-ABRASIVE GRAIN FIXED TYPE WIRE SAW**

(30) Priority: 05.11.2009 JP 2009254310; 06.10.2010 JP 2010226829
(71) Applicant: Nakamura Choko Co., Ltd, Sakai-shi, Osaka 593-8323 (JP)
(72) Inventor: OTANI Yasuhiko, Kobe-shi Hyogo 655-0016 (JP); TOMIYOSHI Tsutomu, Izumi-shi Osaka 594-1157 (JP); HAGIHARA Yoshihiro, Izumi-shi Osaka 594-1157 (JP); KUBO Kenji, Izumi-shi Osaka 594-1157 (JP); INOUE Hiroaki, Izumi-shi Osaka 594-1157 (JP); TAKAGI Toshihide, Izumi-shi Osaka 594-1157 (JP); SHIMADA Hideaki, Sakai-shi Osaka 593-8323 (JP); FUKUMOTO Masahito, Sakai-shi Osaka 593-8323 (JP); SHIMONO Kazuhiro, Osaka-shi Osaka 559-0024 (JP)
(74) Representative: Vossius & Partner
(86) International application number: PCT/JP2010/069294
(87) International publication number: WO 2011/055692

(57) **Abstract**

The super-abrasive grain fixed type wire saw is equipped with two layers consisting of a brazing material layer (13) and a metal plating layer (16), the aforementioned brazing material layer (13) serving to temporarily fix super-abrasive grains (14), and the aforementioned metal plating layer (16) serving to hold the super-abrasive grains (14). The thickness of the brazing material layer (13) is 10% or less of the average grain diameter of the super-abrasive grains (14). The brazing material layer (13) is formed on the surface of a wire (10) in advance. The super-abrasive grains (14) are dispersed and adhered in a single layer onto the brazing material layer (13). Subsequently, the surface of the brazing material layer (13) is melted and solidified, resulting in a super-abrasive-grains-temporarily-adhered wire (12) such that super-abrasive grains (14) are joined to the adhesion surface of the brazing material layer (13). Thereafter, the super-abrasive-grains-temporarily-adhered wire (12) is metal-plated.

## Description

### Technical Field

The present invention relates to a super-abrasive grain fixed type wire saw suitable as cutting tools for hard materials such as silicon, ceramics, and sapphire.

### Background Art

At the present time, slice processing of hard materials such as silicon, ceramics, and sapphire by a multi-wire saw generally employs diamond wire tools having a wire surface onto which diamond abrasive grains are fixed. For these diamond wire tools, there are now mainly three typical methods for fixing the diamond abrasive grains to a wire. The methods are a method by resin bonding, a method by electrodeposition, and a method by brazing.

The method by resin bonding is performed, for example, by coating a surface of a wire as a piano wire with a mixture of a phenol resin and diamond for sticking the mixture and by curing the phenol resin to fix the diamond to the wire. The method achieves high productivity, can control the amount of super-abrasive grains, and can manufacture a long wire saw at low cost. However, the diamond grains fall one after another during the wire saw is used because the resin has low holding power. This leads to the deterioration of cutting quality, the reduction in wire diameter, and the like and consequently causes a disadvantage of a short service life. To address this, in order to increase the abrasive grain holding power of a resin bonding wire saw, there is disclosed a wire saw having a surface on which a metal layer is formed by plating (see Patent Document 1). However, the joining power between a wire surface and a resin basically affects the holding power of super-abrasive grains, and the peeling strength between the metal layer and the resin layer has a limit since the metal layer is basically formed on the resin surface. Thus, such a wire saw cannot ensure a sufficient holding power suitable for cutting a hard substance.

The method by electrodeposition is performed by nickel plating for fixing diamond. For example, diamond filled in a cloth bag is immersed in a nickel plating solution; a wire as a piano wire is passed through the cloth bag to make the wire a cathode; and a nickel anode provided in the plating solution is energized. On the wire in the diamond and the plating solution, nickel is deposited to enlarge the wire diameter. At this time, the diamond is incorporated into a nickel membrane and weakly fixed to the wire surface. This plating is continuously performed while the wire is slowly taken up. The wire out from the cloth bag is successively plated in the plating solution until the deposited nickel reaches a predetermined thickness. The diamond fixed by the electrodeposition method has comparatively high holding power. However, in the method, the production is very slow because the diamond fixing depends on the plating deposition rate, resulting in unsatisfactory productivity and high cost. In addition, the method is difficult to control the adhesion amount of super-abrasive grains, for example, to increase the adhesion amount.

As the method by brazing, there is disclosed a wire saw that includes a metal wire and super-abrasive grains fixed to the wire by a brazing metal joining material or a soldering metal joining material (for example, see Patent Documents 2 and 3). In the brazing method described in Patent Document 2, the use of the brazing metal joining material requires heat treatment at 800 to 950°C, and hence a cheap wire such as a high-strength carbon steel wire cannot be used as a wire saw because the strength is greatly reduced. In Examples, a high-carbon steel was used as the wire and was brazed at 880°C for 30 minutes under vacuum, but such a wire is unlikely to be practicable in terms of the strength. Another example in the same Patent Document 2 also describes, as an example using the soldering metal joining material, that an Inconel 718 wire having a diameter of 250 µm was drawn through a paste of a solder composition of metal (99 g of 96% Sn/4% Ag powder and 1 g of Cu powder) mixed with a proper amount of diamond powder into a tube furnace at 350°C to give a diamond coated wire. However, the holding power of the diamond abrasive grains is principally affected by the strength of Sn and is lower than that by the nickel electrodeposition.

Patent Document 3 discloses a method by brazing in order to solve the disadvantages and problems of the resin bonding method and the electrodeposition method, and the method also employs fixing by a brazing material in order to secure the fixing strength. It is described that, as the brazing material, for example, a Cu-Ag-Ti alloy (having a melting temperature of 700°C or more) is desirably adopted and, for such an alloy, a tungsten wire of which strength is not reduced even when the wire is exposed to high temperature is desirably used as the wire rod. A piano wire and a high-carbon steel wire that are widely used as the wire rod cannot be used and this reduced the advantages in cost. Furthermore, the brazing at high temperature requires brazing in a vacuum or in an inert gas atmosphere and this causes problems of complicated facilities or operation. In order to overcome the problems, there are disclosed the adoptions of a brazing material that melts at 500 to 600°C and of a stainless steel wire of which strength is not reduced by 20% or more at the time of heat treatment (see Patent Document 4). However, such a wire is inferior in strength and cost to those composed of piano wire or high-carbon steel and still has problems. In other words, although the brazing method can control the amount of super-abrasive grains, it requires a high temperature brazing material for achieving the abrasive grain holding power as strong as that by the electrodeposition method, and thus needs a heat resistant core wire such as a tungsten wire to increase the cost.

Moreover, the difference of thermal expansion coefficient between super-abrasive grains and a brazing material causes internal stress in the super-abrasive grains after brazing and thus the super-abrasive grains are susceptible to cracking and chipping. In order to solve the problem, there is disclosed a wire saw that is manufactured by fixing super-abrasive grains to a wire surface by brazing and then burying the super-abrasive grains by plating (see Patent Document 5). More specifically, diamond abrasive grains are temporarily fixed onto a wire surface with an adhesive; a brazing material powder is filled between the temporarily fixed diamond abrasive grains and is melted in a vacuum furnace and solidified to bury about 35% of the average grain diameter of the diamond abrasive grains for holding; and then nickel plating is performed on the diamond abrasive grains to bury 70% of the average grain diameter. However, as in Patent Document 5, the diamond abrasive grains of which 35% of the average grain diameter is buried in a brazing material layer interfere with cutting chip discharge to reduce processing accuracy. Furthermore, during processing, the super-abrasive grains fall into the brazing material layer to sink and thus the protrusion amount of the diamond abrasive grains is reduced, resulting in the reduction in cutting capability. Moreover, in the method in which a brazing material powder is filled between diamond abrasive grains that are temporarily fixed onto a wire and is melted and solidified, such an operation is very complicated to require effort and cost. In addition, the method unavoidably forms voids between the diamond abrasive grains and the brazing material layer and hence the diamond abrasive grains move during processing, resulting in the reduction in processability or falling of the super-abrasive grains. The nickel plating is also likely to form voids near interfaces between the diamond abrasive grains, the brazing material layer, and the metal plating layer and similarly causes the reduction in processability and the falling of the super-abrasive grains.

### Citation List

### Patent Literatures

Patent Document 1: JP-A No. 2007-253268
Patent Document 2: Japanese Patent No. 4008660
Patent Document 3: JP-A No. 2006-123024
Patent Document 4: JP-A No. 2008-221406
Patent Document 5: JP-A No. 2002-205272

### Summary of Invention

### Technical Problem

In view of the above circumstances, it is an object of the present invention to provide a super-abrasive grain fixed type wire saw that can solve all of the problem of a short service life in the resin bonding method, the problem of unsatisfactory productivity and high cost in the electrodeposition method, and the problems of cost disadvantages because a high-carbon steel cannot be used and of super-abrasive grains susceptible to cracking and chipping due to internal stress caused in the super-abrasive grains after brazing in the brazing method and that has a long service life, high productivity, and excellent cutting capability.

### Solution to Problem

In order to solve the above problems, the present invention provides a super-abrasive grain fixed type wire saw having a wire surface onto which super-abrasive grains are dispersed and fixed, the wire saw is characterized by having two layers including a brazing material layer temporarily fixing the super-abrasive grains and a metal plating layer holding the super-abrasive grains, and the brazing material layer has a thickness of 10% or less of an average grain diameter of the super-abrasive grains. Here, the average grain diameter is determined by common laser diffraction and scattering method.

In the wire saw, it is preferred that the super-abrasive grains are held on the wire surface by forming the brazing material layer on the wire surface, dispersing and adhering the super-abrasive grains onto the brazing material layer, then melting and solidifying a surface of the brazing material layer to temporarily fix the super-abrasive grains onto an adhesion surface of the brazing material layer, and thereafter forming the metal plating layer by plating treatment.

It is preferred that the brazing material layer has a thickness of 1% or more and less than 5% of the average grain diameter of the super-abrasive grains.

It is preferred that the metal plating layer is a nickel plating layer or a nickel alloy plating layer.

It is preferred that the brazing material layer is composed of an Sn solder, an Sn-Cu alloy solder, an Sn-Ag alloy solder, or an Sn-Sb alloy solder.

The present invention also provides a super-abrasive grain fixed type wire saw having a wire surface onto which super-abrasive grains are dispersed and fixed, the wire saw is manufactured by forming a brazing material layer on the wire surface, dispersing and adhering the super-abrasive grains in a single layer onto the brazing material layer, then melting and solidifying a surface of the brazing material layer to form a super-abrasive-grains-temporarily-adhered wire, the super-abrasive grains being joined to an adhesion surface of the brazing material layer, and thereafter forming a metal plating layer by plating treatment of the super-abrasive-grains-temporarily-adhered wire, and the wire saw is composed of two layers including the brazing material layer temporarily fixing the super-abrasive grains and the metal plating layer holding the super-abrasive grains.

The present invention also provides a method of manufacturing a super-abrasive grain fixed type wire saw having a wire surface onto which super-abrasive grains are dispersed and fixed, the method includes forming a brazing material layer on the wire surface in advance, dispersing and adhering the super-abrasive grains in a single layer onto the brazing material layer, then melting and solidifying a surface of the brazing material layer to form a super-abrasive-grains-temporarily-adhered wire, the super-abrasive grains being joined to an adhesion surface of the brazing material layer, and metal-plating the super-abrasive-grains-temporarily-adhered wire to fix the super-abrasive grains onto the wire surface.

### Advantageous Effects of Invention

A first aspect of the invention includes two layers including a brazing material layer temporarily fixing super-abrasive grains and a metal plating layer holding the super-abrasive grains, the super-abrasive grains such as diamond grains are temporarily adhered onto the wire by the brazing material layer, and thereafter the wire onto which the super-abrasive grains are temporarily adhered is metal-plated to fix the super-abrasive grains. Therefore, the holding power of the super-abrasive grains is very high compared with that by the resin bonding method. It is also possible to achieve higher production speed than that by the electrodeposition method and to readily control the amount of the super-abrasive grains because the super-abrasive grains are temporarily fixed by the brazing material layer. In particular, the brazing material layer has a thickness of 10% or less of the average grain diameter of the super-abrasive grains. Thus, such a wire saw eliminates the problem of the super-abrasive grains susceptible to cracking and chipping by the internal stress caused in the super-abrasive grains after brazing due to the difference of thermal expansion coefficient between the super-abrasive grains and the brazing material. Such a wire saw can achieve good cutting chip discharge and maintain excellent processing accuracy. Such a wire saw can also avoid the sinking of the super-abrasive grains into the brazing material layer during processing and can maintain the protrusion amount of the super-abrasive grains to maintain the cutting capability.

According to a second aspect of the invention, fillets are formed between the brazing material layer and the super-abrasive grains when the super-abrasive grains are temporarily fixed by the brazing material layer and such a fillet leads to a strong joint without clearance by the brazing material and metal plating to suppress stress concentration to an adhesion area of the super-abrasive grains. Therefore, the wire saw including a brazing material layer even having a thickness of 10% or less of the average grain diameter of the super-abrasive grains has a higher abrasive grain holding power than that of a wire saw in which the spaces between the super-abrasive grains are filled with the brazing material layer to about 35% of the average grain diameter and then the wire is metal plated. Moreover, the complicated operation of filling a brazing material powder between diamond abrasive grains is not required, and this leads to excellent productivity. Furthermore, the wire saw having better durability (abrasive grain holding power) than that by the electrodeposition method can be provided. In addition, the disadvantage of poor cutting chip discharge due to excessively large fillets can be avoided.

According to a third aspect of the invention, the brazing material layer has a thickness of 1% or more and less than 5% of the average grain diameter of the super-abrasive grains. This further improves the processing accuracy and also suppresses variations in the thickness of a processed article during slice processing.

According to a fourth aspect of the invention, the metal plating layer is a nickel plating layer or a nickel alloy plating layer, and hence such a wire saw has a high abrasive grain holding power.

According to a fifth aspect of the invention, compared to the brazing method, the use of a solder enables the manufacture at a temperature of two hundred and several tens or less, and thus a cheap high-carbon steel wire such as a piano wire can be used in addition to a tungsten wire and a stainless steel wire. Moreover, a complicated apparatus using a vacuum furnace is not required, and this can reduce the cost.

According to sixth and seventh aspects of the invention, super-abrasive grains such as diamond grains are temporarily fixed onto a wire by a brazing material layer such as solder and then the wire onto which the super-abrasive grains are temporarily fixed is plated with a metal such as nickel for fixing the super-abrasive grains. Therefore, the abrasive grain holding power is greatly higher than that by the resin bonding method. It is possible to achieve higher production speed than that by the electrodeposition method and easy control of the amount of the super-abrasive grains because the super-abrasive grains are temporarily fixed by the brazing material layer. Furthermore, at the time of the temporarily fixing, fillets are formed between the brazing material layer such as solder and the super-abrasive grains and then the metal plating is performed on the wire. Hence, the robust fillet by the brazing material and the metal plating leads to a robust joint without clearance to prevent stress concentration to an adhesion area of the super-abrasive grains. Therefore, a wire saw having more excellent durability (abrasive grain holding power) than that by the electrodeposition method can be provided.

### Brief Description of Drawings

Fig. 1 is a cross-sectional view showing a wire saw of a typical embodiment of the present invention.
Figs. 2(a) to 2(d) are schematic diagrams showing a procedure for manufacturing the wire saw.
Fig. 3 is a schematic view showing a manufacturing process of a first step.
Fig. 4 is a schematic view showing manufacturing processes of second and third steps.
Fig. 5 is a schematic view showing a manufacturing process of a fourth step.
Fig. 6(a) is a cross-sectional view showing an alternative embodiment of the wire saw and Fig. 6(b) is an enlarged sectional view of the part A.
Figs. 7 are magnified photographs of wire saws of Example 1 and Comparative Example 1.
Fig. 8(a) is a photograph of a wire saw of Example 2 before processing and Fig. 8(b) is a magnified photograph of the wire saw.
Fig. 9(a) is a photograph of a wire saw of Example 3 before processing and Fig. 9(b) is a magnified photograph of the wire saw.
Figs. 10 are graphs showing results of a processing test by the wire saw of Example 2.
Figs. 11 are graphs showing results of a processing test by the wire saw of Example 3.

### Reference Signs List

- 1: Wire saw
- 10: Wire
- 11: Precoated wire
- 12: Super-abrasive-grains-temporarily-adhered wire
- 13: Brazing material layer
- 13a: Fillet
- 14: Super-abrasive grain
- 15: Liquid layer
- 16: Metal plating layer
- 20: Supply reel
- 21: Fluxing apparatus
- 22: Melted solder bath
- 23: Cooling zone
- 24: Take-up reel
- 30: Supply reel
- 31: Liquid coating apparatus
- 32: Super-abrasive grain adherence zone
- 32a: Super-abrasive grain dispersion apparatus
- 33: Furnace
- 34: Cooling zone
- 40: Supply reel
- 42: Defatting bath
- 43: Acid washing bath
- 44: Water washing bath
- 45: Plating bath
- 45a: Direct-current power source
- 45b: Load-dispatching roll
- 45c: Anode
- 46: Water washing bath
- 47: Take-up reel

### Description of Embodiments

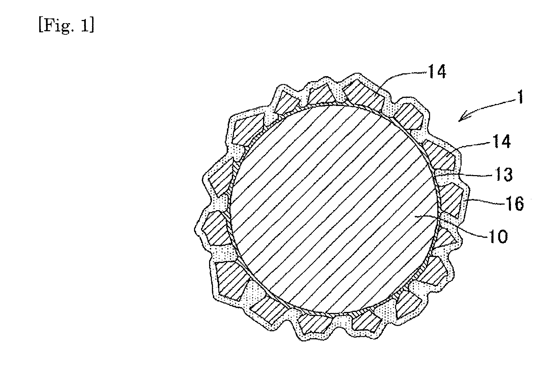

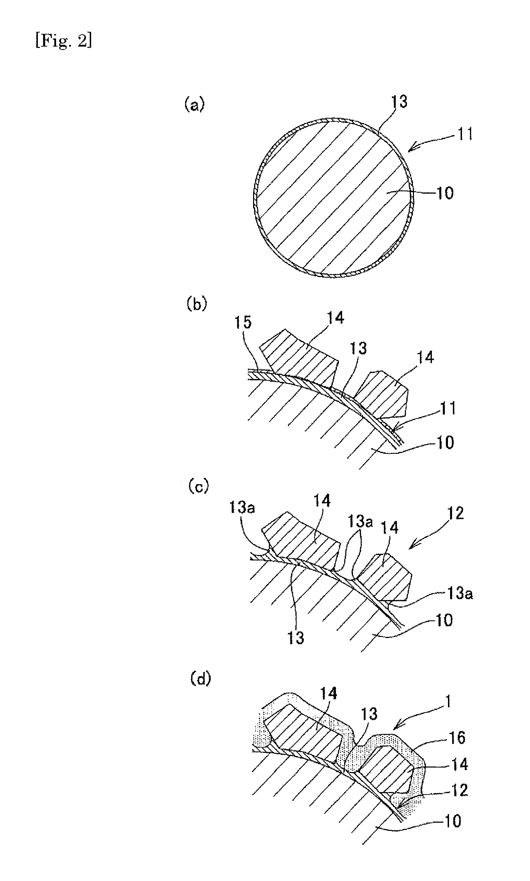

Next, embodiments of the present invention will be described in detail based on attached drawings. Fig. 1 is a cross-sectional view showing a super-abrasive grain fixed type wire saw of the present invention and Figs. 2 are schematic diagrams showing a manufacturing process of the wire saw. In the drawing, the sign 1 represents a wire saw, the sign 10 represents a wire, the sign 13 represents a brazing material layer, the sign 14 represents a super-abrasive grain, and the sign 16 represents a metal plating layer.

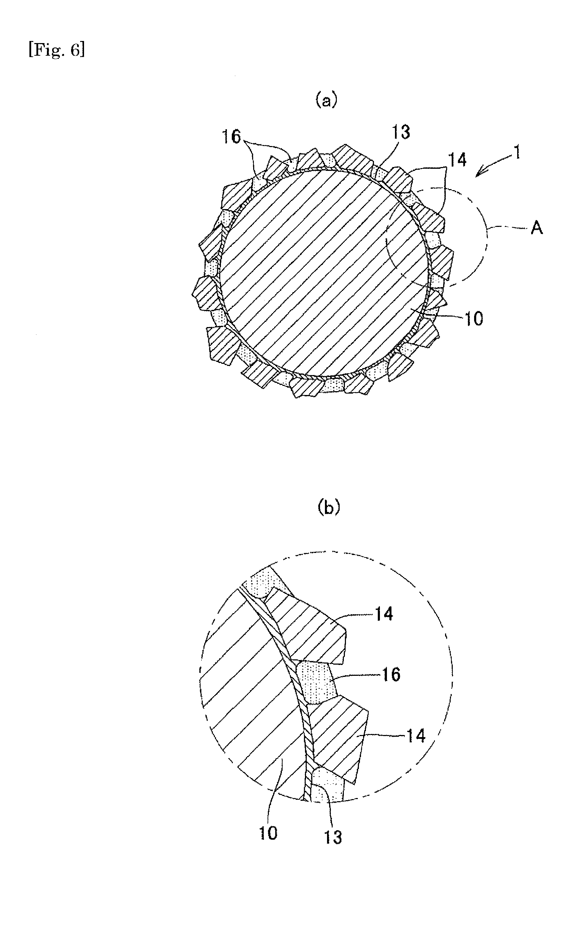

The wire saw 1 of the present invention includes, as shown in Fig. 1, a wire 10 having a surface onto which super-abrasive grains 14 are dispersed and fixed. A brazing material layer 13 is formed on the surface of the wire 10, the super-abrasive grains 14 are temporarily fixed in a single layer onto the brazing material layer 13, and the wire is metal-plated to fix and hold the super-abrasive grains 14 onto the surface thereof. In the embodiment, the metal plating layer 16 covers also the super-abrasive grains 14 because the used super-abrasive grains 14 have surfaces with conductivity. However, the present invention is not limited to the embodiment, and super-abrasive grains having surfaces without conductivity may also be used. In such a case, as shown in Figs. 6(a) and 6(b), the metal plating layer 16 is grown on the brazing material layer 13 between the super-abrasive grains 14 to fill up interstices without clearance between the super-abrasive grains 14, and each super-abrasive grain 14 is enclosed. As a result, the super-abrasive grains 14 are firmly fixed.

As the wire 10, various metal wires of which strength is not reduced at the melting temperature of solder can be used and a suitably used wire is composed of any of iron, nickel, cobalt, chromium, tungsten, molybdenum, copper, titanium, aluminum, and an alloy of them. In particular, a wire composed of high-carbon steel containing a piano wire is preferred because such a wire is inexpensively and stably available to reduce cost.

For the brazing material layer 13, an Sn solder, an Sn-Cu alloy solder, an Sn-Ag alloy solder, or an Sn-Sb alloy solder is preferably used. The reason why these solder components are preferred is as follows. That is, a metal joining material having a melting point of 450°C or less is generally referred to as a solder. However, the present invention intends to provide a wire saw that is relatively inexpensive and that includes a wire composed of high-strength high-carbon steel including a piano wire onto which super-abrasive grains are fixed. The strength of the high-carbon steel such as piano wire is reduced when the high-carbon steel is exposed to a thermal environment at more than about 300°C for a predetermined period of time or more. Thus, a solder to be applied to the present invention is desirably a solder having a melting point of 300°C or less and desirably 270°C or less. With the above component a solder having a melting point of 300°C or less can be designed and produced. The brazing material layer 13 has a thickness of 10% or less of the average grain diameter of the super-abrasive grains 14. More preferably, the thickness is 1% or more and less than 5% of the average grain diameter of the super-abrasive grains.

The super-abrasive grains 14 to be used may be various super-abrasive grains that are conventionally used as a wire saw. In order to cut down a highly hard material such as silicon, ceramics, and sapphire, as intended by the present invention, any of diamond, CBN, and SiC or a mixture of them is preferably used because super-abrasive grains of such a substance have high hardness.
The super-abrasive grains 14 are covered with nickel, copper, or titanium metal for good joining properties with respect to solder. Especially, super-abrasive grains coated with nickel or copper are preferred because such grains can ensure wettability to a brazing material to maintain adhesion strength.

The metal plating layer 16 is preferably a plating composed of the same metal to the super-abrasive grains 14 or to a metal applied to the super-abrasive grains because such a metal can increase inter-adhesiveness. For example, with respect to nickel-coated diamond abrasive grains 14, a nickel plating layer or a nickel alloy plating layer is preferably formed by electroplating.

Hereinafter, the wire saw 1 will be described in detail with reference to a manufacture procedure. The manufacture of the wire saw 1 includes four major steps.

### (First Step)

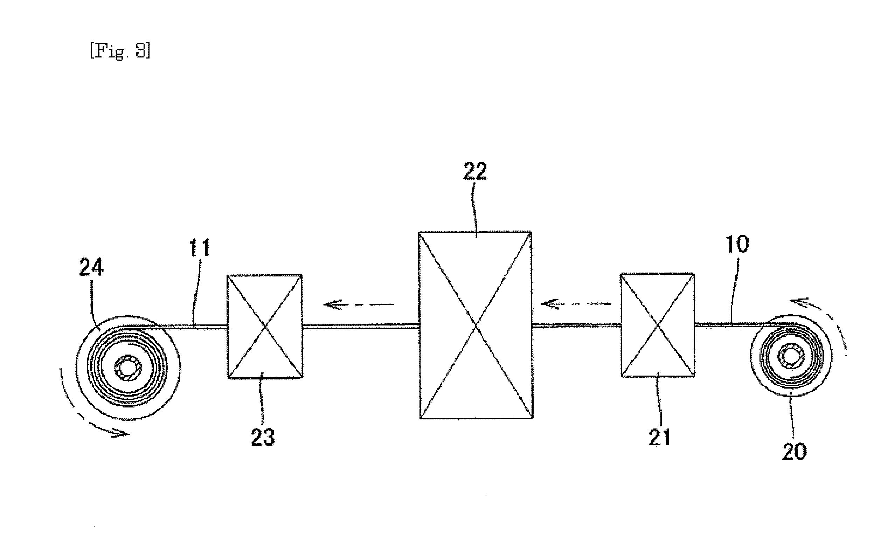

The first step is, as shown in Fig. 2(a), a step of forming a brazing material layer 13 on a surface of a wire 10. The brazing material layer 13 is formed, for example, by melting a solder in a crucible and passing a wire through the melted solder. Fig. 3 is a schematic view showing a manufacturing process in the first step. In the process, a wire 10 supplied from a wire supply reel 20 is passed through a fluxing apparatus 21 and then through a melted solder bath 22 for forming a brazing material layer (solder layer) on the surface, then is passed through a cooling zone 23 for solidifying the brazing material layer, and is taken up onto a take-up reel 24 as a precoated wire 11.

Examples of the fluxing apparatus 21 include an apparatus employing a method of spraying a flux from a nozzle and an apparatus employing a method of passing a wire through a flux storage bath. The melted solder bath 22 is equipped with a heater that can thoroughly melt a solder. The melted solder bath is also equipped with a guiding apparatus so as to pass a wire through the melted solder bath and thus the wire 10 is passed through the melted solder. Simultaneously, on the surface of the wire 10, the brazing material layer 13 (solder layer) is formed. Though the melted solder has nearly been solidified when the wire leaves the melted solder bath 22, in order to further ensure the solidification, the cooling zone 23 is provided before the wire is taken up onto the take-up reel 24. As described above, Fig. 2(a) shows a cross-sectional view of the manufactured wire after the first step and shows a state of the wire 10 having a surface on which the brazing material layer 13 is formed. The wire is referred to as a precoated wire 11.

The thickness of the brazing material layer 13 (solder layer) formed in the first step varies depending on the viscosity and surface tension of a melted solder and the running speed of a wire. However, as described above, the thickness is preferably 10% or less of the average grain diameter of the super-abrasive grains 14 and more preferably 1% or more and less than 5%. Specifically, the thickness is preferably 2 µm or less for super-abrasive grains having an average grain diameter of 40 to 60 µm and is preferably 1 µm or less for super-abrasive grains having an average grain diameter of 10 to 20 µm. The embodiment employs hot-dip plating, but the metal plating layer, of course, can be formed, for example, by electroplating of tin.

### (Second Step)

In the second step, as shown in Fig. 2(b), super-abrasive grains 14 are dispersed and adhered in a single layer onto the brazing material layer 13 formed in the first step. For example, the surface of the precoated wire 11 manufactured in the first step is wetted with a liquid that is decomposed or evaporated at the melting temperature of a solder or less. The wetted wire is passed through a container containing super-abrasive grains and the super-abrasive grains are adhered onto the wire surface due to the wet. In this case, it is actually observed that super-abrasive grains are present on other super-abrasive grains due to inter-cohesive power of the super-abrasive grains, which is not shown in Fig. 2(b).

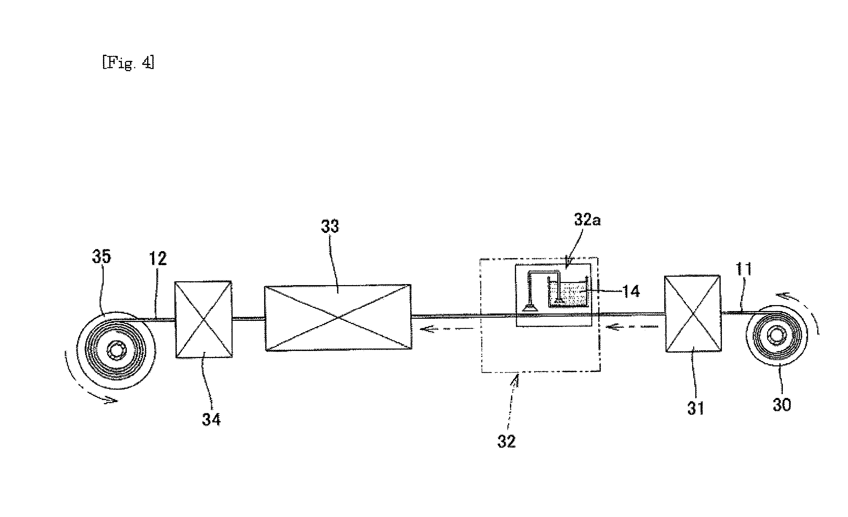

More specifically, as shown in the schematic view in Fig. 4, the surface of the precoated wire 11 that is supplied from a supply reel 30 is wetted with a liquid coating apparatus 31. Then, the precoated wire 11 having the wetted surface is passed through a super-abrasive grain dispersion apparatus 32a in a super-abrasive grain adherence zone 32, and super-abrasive grains 14 are adhered onto the surface. These processes are the second step. Consequently, as shown in Fig. 2(b), a liquid layer 15 is formed on the surface of the brazing material layer 13 of the precoated wire 11, and the super-abrasive grains 14 are adhered onto the surface of the precoated wire 11 due to the wet of liquid. Here, the step is preferably equipped with a function of controlling the adhesion density of super-abrasive grains by the control of the wire running speed or the like.

There are other possible methods of performing the second step. For example, the second step can be performed by passing the precoated wire having a surface that is similarly wetted through a storage bath of a super-abrasive grain powder or by adhering super-abrasive grains onto the precoated wire using the principle of electrostatic coating. The adhesion can be also achieved by simple van der Waals force or by static electrification. Each method is also characterized by the control of the adhesion amount of super-abrasive grains by the control of wire running speed or the amount of spray.

### (Third Step)

In the third step, the brazing material layer 13 on the wire onto which the super-abrasive grains 14 are temporarily fixed in the second step is heated and melted, and then the brazing material layer is cooled and solidified to adhere the super-abrasive grains 14 onto the surface of the brazing material layer 13 for temporary adhesion (temporary fixing). Specifically, the step is performed subsequent to the second step, as shown in the schematic view in Fig. 4. The super-abrasive-grains-adhered precoated wire that is passed through the super-abrasive grain dispersion apparatus 32 is guided into a furnace 33 to be heated. The furnace 33 can heat to a temperature sufficient to melt the brazing material layer 13 of the precoated wire. In the furnace 33, a liquid in the adhering liquid layer 15 is evaporated and a solder in the brazing material layer 13 is simultaneously melted. Therefore, the contact face of the super-abrasive grains 14 to the wire is wetted with the brazing material layer 13 in place of the evaporated liquid in the liquid layer 15. The wire leaves the furnace 33 and is passed through a cooling zone 34, resulting in the solidification of the brazing material layer 13. Consequently, the super-abrasive grains 14 are joined onto the wire.

Fig. 2(c) shows the cross section of the wire after the step, showing the state in which the melted solder in the brazing material layer 13 is drawn to the periphery of the super-abrasive grains 14 due to surface tension and then solidified to form fillets 13a. That is, the advantage of the method is that the fillets 13a are formed around the adhesion face of the super-abrasive grains 14 and thus the super-abrasive grains 14 are stably joined. The presence of the fillets 13a leads to smooth metal plating around the super-abrasive grains 14 in the following step and hence can provide a wire saw having high abrasive grain holding power unlike the joining state of super-abrasive grains by the electrodeposition by which no fillet 13a is formed.

The super-abrasive grains that are excessively adhered onto the super-abrasive grains 14 due to the inter-cohesive power of the super-abrasive grains in the second step are not in contact with the brazing material layer 13. Hence, these grains are not joined to the wire in the third step and are removed, for example, by air flow in the cooling zone 34. Accordingly, the super-abrasive grains 14 on the wire form a single layer. Hereinafter, the wire manufactured in the third step is referred to as a super-abrasive-grains-temporarily-adhered wire 12. The adhesive strength of the super-abrasive grains to the wire depends on the adhesive strengths between a solder in the brazing material layer 13 and the super-abrasive grains and between the solder and the wire. However, the adhesive strength is insufficient since nearly one face alone on the super-abrasive grain is adhered, and such a wire in the state cannot be used as a wire saw. Therefore, when such a wire is used as the wire saw, the super-abrasive grains are required to be more firmly fixed onto the wire in the fourth step described below.

### (Fourth Step)

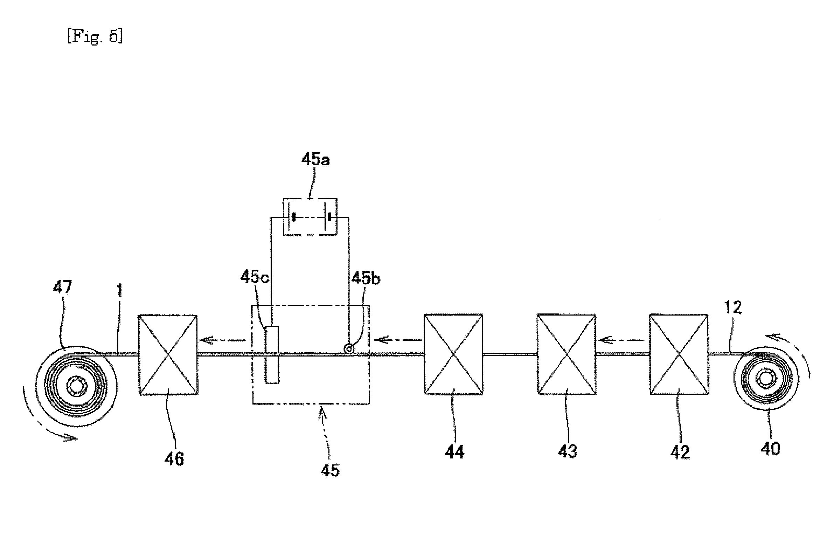

In the fourth step, as shown in Fig. 2(d), the super-abrasive-grains-temporarily-adhered wire 12 is metal-plated to firmly fix the super-abrasive grains 14 onto the wire. Fig. 5 is a schematic view showing a manufacturing process of the fourth step. In the apparatus, the super-abrasive-grains-temporarily-adhered wire 12 that is manufactured in the third step is supplied from a supply reel 40, is passed through a defatting bath 42, an acid washing bath 43, a water washing bath 44, a plating bath 45, and a water washing bath 46, and is taken up onto a take-up reel 47.

The plating bath 45 is equipped with an anode 45c and a load-dispatching roll 45b to make the wire a cathode and with a direct-current power source 45a. During the wire is passed through the plating bath 45, a metal plating layer is formed on the surface of the super-abrasive-grains-temporarily-adhered wire 12. When the super-abrasive grain surface has conductivity, the metal plating layer is formed not only on the brazing material layer on the wire but also on the super-abrasive grains, and hence the super-abrasive grains are very firmly fixed onto the wire. The super-abrasive grain-fixed wire having the cross sections in Fig. 2(d) and Fig. 1 can be obtained. The thickness of the metal plating can be controlled by wire running speed and plating current. The metal plating also covers the surface of the super-abrasive grains 14 in the case of the super-abrasive grains 14 coated with a conductive material as in the embodiment. Hence, a metal plating formed in the fourth step having an excessively large thickness requires a certain amount of time for dressing of the wire before use to reduce efficiency. Therefore, the thickness is preferably 3 to 10 µm and more preferably 3 to 5 µm.

Hereinbefore, the embodiment of the present invention has been described, but the present invention is not intended to be limited to such an embodiment, and various changes and modifications may be made without departing from the scope of the present invention.

### Examples

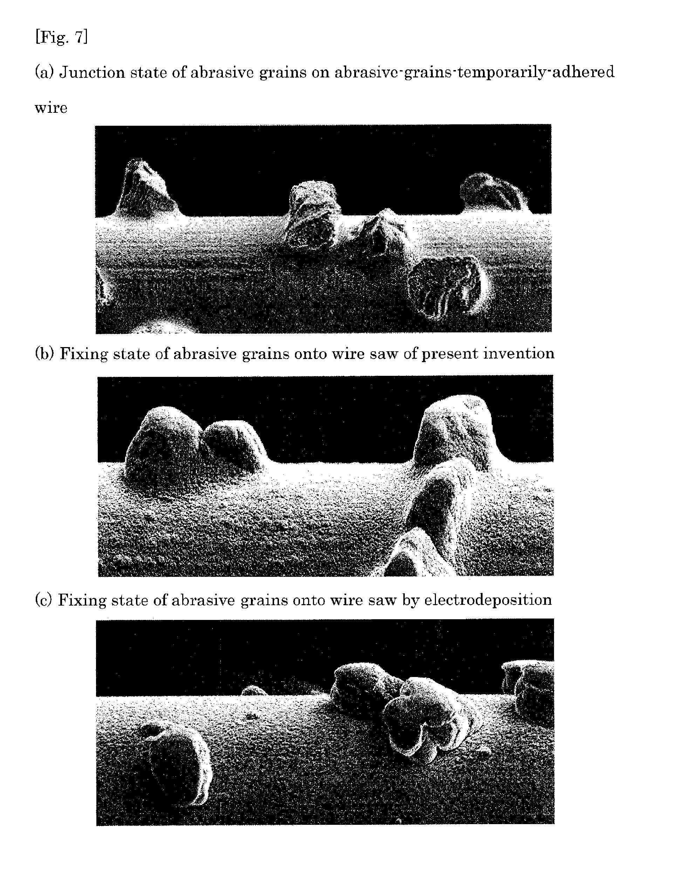

Next, a wire saw of Example 1 manufactured by the manufacturing method of the present invention and a wire saw of Comparative Example 1 manufactured by the electrodeposition method will be described based on the photographs in Figs. 7.

The wire saw of Example 1 was manufactured by using the processes in Figs. 3 to 5 described above. A brass plated piano wire having a diameter of 180 µm was used as the wire and a solder plating layer having a thickness of 2 to 2.5 µm was formed using an Sn-Ag alloy solder having a melting temperature of 220°C to prepare a precoated wire. The precoated wire was wetted with a liquid, then nickel coated diamond abrasive grains having a size of 30 to 40 µm were dispersed and adhered at a wire running speed of 20 m/minute, and the solder was melted and solidified to prepare a super-abrasive-grains-temporarily-adhered wire. Fig. 7(a) is a magnified photograph of the super-abrasive-grains-temporarily-adhered wire. The solder was drawn to the periphery of the super-abrasive grains to form fillets. Hence, the thickness of the solder plating layer around the wire seems to be on the submicron-level.

Next, the super-abrasive-grains-temporarily-adhered wire was nickel plated at a wire running speed of 10 m/minute and a current of 20 A until the thickness reached 10 µm. Fig. 7(b) is a magnified photograph of the completed wire saw after the metal plating. It can be seen that the metal plating layer also covers the fillets and the super-abrasive grains are fixed with the grains completely covered.

In the wire saw of Comparative Example 1, the diamond abrasive grains were fixed onto the wire by the electrodeposition. The wire had a diameter of 180 micron, the super-abrasive grains were diamond abrasive grains (an average grain diameter of 30 to 40 micron), and the electrodeposition material was nickel.

Fig. 7(c) is a magnified photograph of the wire saw of Comparative Example 1. A black shadow may appear around the adhesion surface of the super-abrasive grains coated with the metal plating. This shows that the metal plating was not thoroughly adhered to interstices around the adhesion surface and the metal plating on the wire surface and the metal plating on the super-abrasive grain surface were not thoroughly bonded because there was no fillet of a solder plating layer as a primary coating of the metal plating as in Example 1.

When a wire saw is used, a force is applied to the super-abrasive grains in the reverse direction to the wire running direction, and a force to peel the super-abrasive grains is applied between the super-abrasive grains and the wire. In the shape in the case by the electrodeposition as in Comparative Example 1, the force generates stress concentration onto the adhesion surface of the super-abrasive grains without the metal plating and the super-abrasive grains are likely to fall. In contrast, in Example 1, the fillet of the solder plating layer was formed around the adhesion surface, and the metal plating was surely formed on the fillet. Such a structure can avoid the stress concentration. It can be seen that this is the reason why the obtained wire saw had better durability (abrasive grain holding power) than that of the wire saw by the electrodeposition method.

Next, as examples of the present invention, two types of wire saws (Example 2 and Example 3) were manufactured and the results of processing test will be described.

### (Example 2)

Wire material: brass plated piano wire
Wire diameter: 179 µm
Brazing material composition: Sn-0.7Cu-0.05Ni-Ge
Average grain diameter of diamond: about 50 µm
Metal plating composition: nickel
Metal plating thickness: 7 µm
Thickness of brazing material layer: about 1 µm
Ratio of thickness of brazing material layer (ratio with respect to average grain diameter of diamond): about 2%

### (Example 3)

Wire material: brass plated piano wire
Wire diameter: 179 µm
Brazing material composition: Sn-0.7Cu-0.05Ni-Ge
Average grain diameter of diamond: about 50 µm
Metal plating composition: nickel
Metal plating thickness: 7 µm
Thickness of brazing material layer: about 2.5 µm
Ratio of thickness of brazing material layer: about 5%

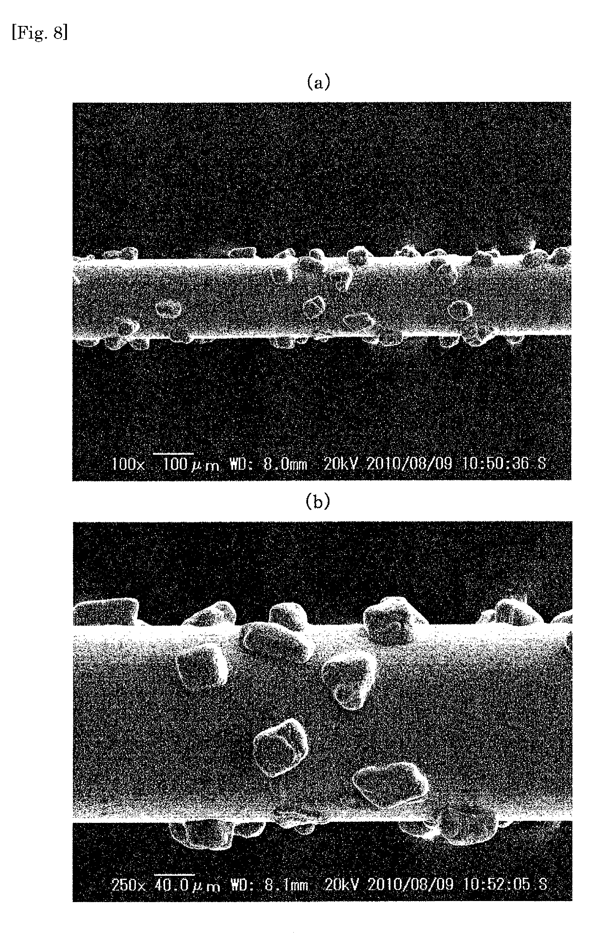

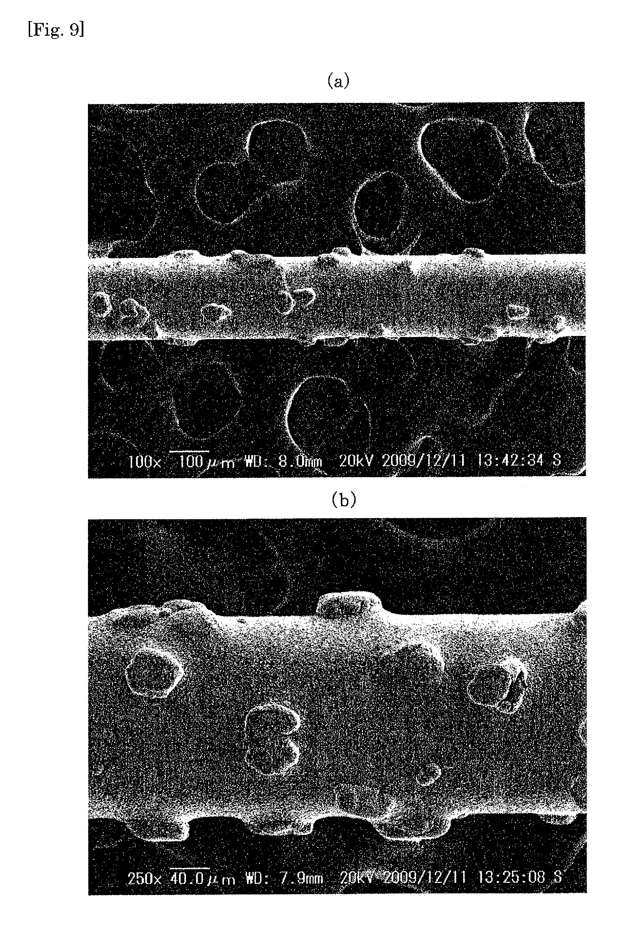

Fig. 8(a) is a photograph of the wire saw of Example 2 before processing and Fig. 8(b) is a magnified photograph of the wire saw. Fig. 9(a) is a photograph of the wire saw of Example 3 before processing and Fig. 9(b) is a magnified photograph of the wire saw. The wire saw including the brazing material layer having a small thickness of about 2% as in Example 2 led to small R on the metal plating surface on the bottom of a diamond grain as shown in Fig. 8. In contrast, the wire saw including the brazing material layer having a thickness of about 5% as in Example 3 led to larger R than that of the wire saw of Example 2 as shown in Fig. 9. This is because that a brazing material layer having a larger thickness leads to a larger fillet that is formed by temporarily fixing a diamond grain onto the brazing material layer and R on the surface of metal plating deposited on the diamond-grains-temporarily-fixed wire is accordingly increased by the fillet.

### (Processing Condition)

Using each wire saw of Example 2 and Example 3, a sapphire ingot having a length of 49 mm was subjected to slice processing at a wire running speed (linear velocity) of 500 m/min to prepare a wafer.

### (Warpage Measurement)

The measurement was carried out using a surface roughness analyzer "SURFCOM-1500-SD3" manufactured by TOKYO SEIMITSU CO., LTD.

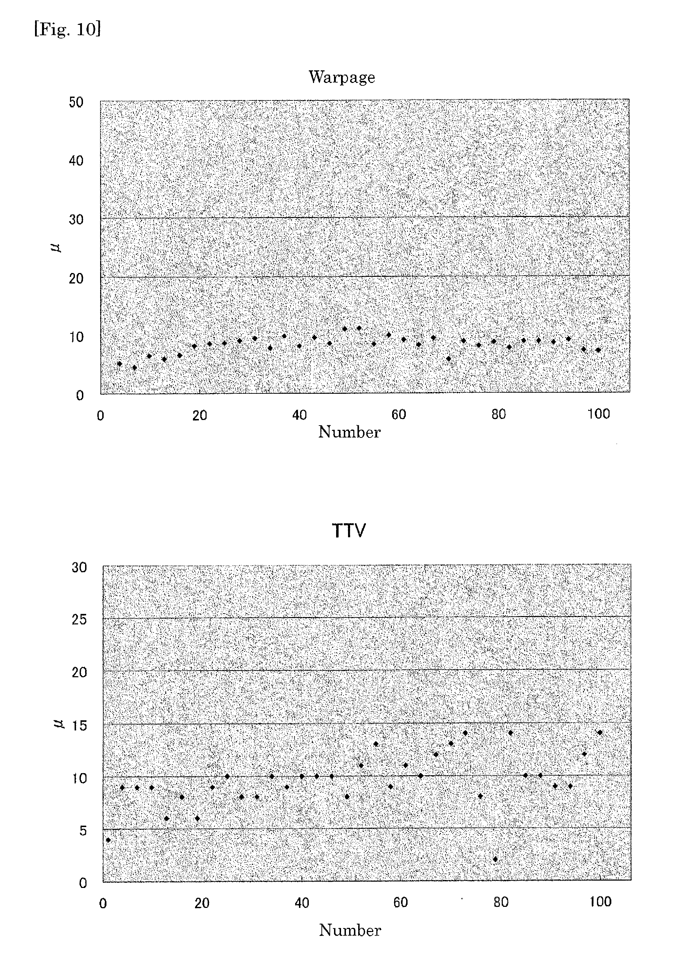

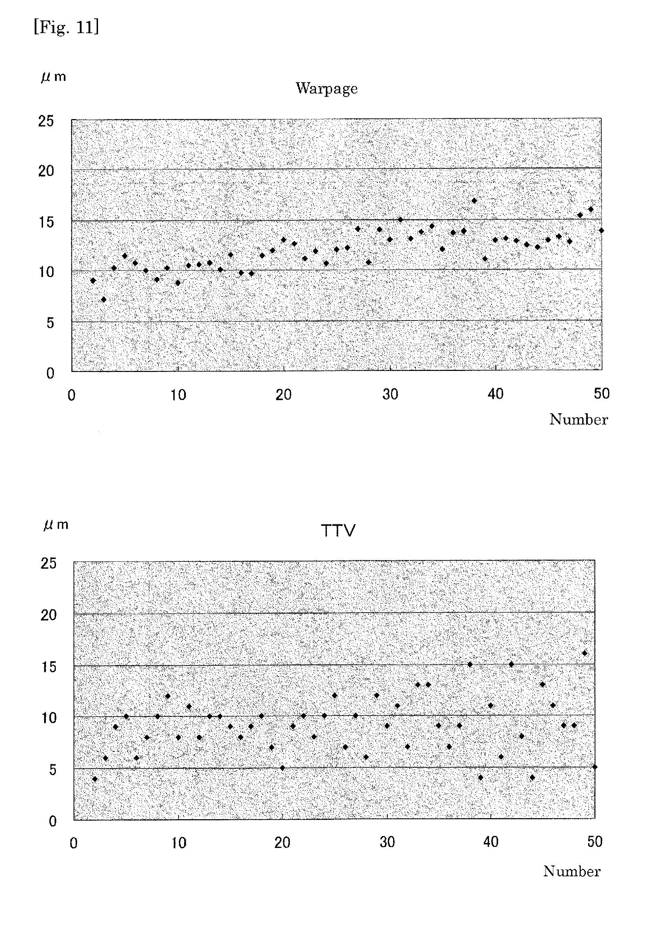

Fig. 10 and Fig. 11 show graphs of the results (warpage and TTV) of the processing test by the wire saws of Example 2 and Example 3, respectively. Thirty-four pieces of wafers manufactured by the slice processing using the wire saw of Example 2 gave a very small warpage mean value of 8.178 µm. In addition, the wire saw achieved small variations in the value and stable processing. Hence, it is clear that the wire saw has excellent processing accuracy. TTV is a variation amount (µm) in the thickness of one wafer and was determined as the difference between a maximum value and a minimum value among thicknesses at three points. The mean value of TTV was as small as 9.529 µm, which shows that the processing achieved uniform thickness. Fifty pieces of wafers manufactured using the wire saw of Example 3 gave a warpage mean value of 12.099 µm. The processing accuracy was inferior to Example 2, but the wire saw achieved excellent processing accuracy. The reason why Example 3 was inferior to Example 2 is supposed that the metal plating surface on the bottom of a diamond grain had relatively large R, the diamond grains did not fall, the cutting chip discharge deteriorated, the wire thickness was not largely reduced, the cutting quality deteriorated, and thus the warpage was increased. The mean value of TTV was as small as 9.020 µm, which shows that the processing achieved uniform thickness.

## Claims

1. A super-abrasive grain fixed type wire saw having a wire surface onto which super-abrasive grains are dispersed and fixed, the wire saw **characterized by** comprising two layers including a brazing material layer temporarily fixing the super-abrasive grains and a metal plating layer holding the super-abrasive grains, the brazing material layer having a thickness of 10% or less of an average grain diameter of the super-abrasive grains.

2. The super-abrasive grain fixed type wire saw according to claim 1, wherein the super-abrasive grains are held on the wire surface by forming the brazing material layer on the wire surface, dispersing and adhering the super-abrasive grains onto the brazing material layer, then melting and solidifying a surface of the brazing material layer to temporarily fix the super-abrasive grains onto an adhesion surface of the brazing material layer, and thereafter forming the metal plating layer by plating treatment.

3. The super-abrasive grain fixed type wire saw according to claim 1 or 2, wherein the brazing material layer has a thickness of 1% or more and less than 5% of the average grain diameter of the super-abrasive grains.

4. The super-abrasive grain fixed type wire saw according to any one of claims 1 to 3, wherein the metal plating layer is a nickel plating layer or a nickel alloy plating layer.

5. The super-abrasive grain fixed type wire saw according to any one of claims 1 to 4, wherein the brazing material layer is composed of an Sn solder, an Sn-Cu alloy solder, an Sn-Ag alloy solder, or an Sn-Sb alloy solder.

6. A super-abrasive grain fixed type wire saw having a wire surface onto which super-abrasive grains are dispersed and fixed, the wire saw being manufactured by forming a brazing material layer on the wire surface, dispersing and adhering the super-abrasive grains in a single layer onto the brazing material layer, then melting and solidifying a surface of the brazing material layer to form a super-abrasive-grains-temporarily-adhered wire, the super-abrasive grains being joined to an adhesion surface of the brazing material layer, and thereafter forming a metal plating layer by plating treatment of the super-abrasive-grains-temporarily-adhered wire, the wire saw being composed of two layers including the brazing material layer temporarily fixing the super-abrasive grains and the metal plating layer holding the super-abrasive grains.

7. A method of manufacturing a super-abrasive grain fixed type wire saw having a wire surface onto which super-abrasive grains are dispersed and fixed, the method comprising:
forming a brazing material layer on the wire surface in advance;
dispersing and adhering the super-abrasive grains in a single layer onto the brazing material layer; then
melting and solidifying a surface of the brazing material layer to form a super-abrasive-grains-temporarily-adhered wire, the super-abrasive grains being joined to an adhesion surface of the brazing material layer; and
metal-plating the super-abrasive-grains-temporarily-adhered wire to fix the super-abrasive grains onto the wire surface.
